# EUROPEAN PATENT SPECIFICATION

(11) **EP 0 398 725 B1**
(45) Date of publication and mention of the grant of the patent: **03.08.1994**
(21) Application number: 90305348.6
(22) Date of filing: 17.05.1990
(51) Int. Cl.: G01J 5/34, H01L 37/02

(54) **Pyroelectric IR - sensor**
Pyroelektrischer IR-Sensor
Capteur d'infrarouge pyroélectrique

(30) Priority: 18.05.1989 JP 125568/89; 18.05.1989 JP 125569/89
(43) Date of publication of application: 22.11.1990
(73) Proprietor: MURATA MANUFACTURING CO., LTD., Nagaokakyo-shi, Kyoto 617 (JP)
(72) Inventor: Ito, Satoru, Machida-shi (JP); Murata, Michihiro, 1-4-8 Nishitakenosatocho, Kyoto-shi (JP); Fukui, Norio, Kyoto-shi (JP); Yamamoto, Keizou, Miyakojima-ku, Osaka-shi (JP); Sawao, Tetsujiro, 609-1 Kubo, Himi-shi (JP); Awata, Satoshi, Fushiki, Takaoka-shi (JP); Tada, Yasuo, Kita-ku, Kyoto-shi (JP); Kawabata, Satoru, Kawase, Hikone-shi (JP)
(74) Representative: Paget, Hugh Charles Edward

(56) References cited:
- EP-A- 0 184 747
- EP-A- 0 313 931
- DE-A- 2 921 298
- DE-A- 3 319 705
- DE-B- 2 017 067
- US-A- 4 825 079
- PATENT ABSTRACTS OF JAPAN vol. 7, no. 23 (P-171)(1168) 29 January 1983, & JP-A-57 175929

## Description

This invention relates to a pyroelectric IR-sensor (infrared sensor), and more particularly to a pyroelectric IR-sensor which has excellent characteristics and is easy in manufacturing.

A conventional pyroelectric IR-sensor, as disclosed in, for example, US specification no. 4682030, essentially comprises a pyroelectric light receiving element, a substrate or base plate of alumina for supporting the pyroelectric light receiving element in a manner that this pyroelectric light receiving element is spaced from the substrate by spacing pads, and provided with a wiring pattern and a resistor formed on the surface thereof, and an FET chip mounted on the substrate.

The method of manufacturing the above-mentioned pyroelectric IR-sensor will be described hereinafter.

At first, a substrate is provided by forming a wiring pattern and a resistor through silk printing and baking on an alumina plate moulded in a predetermined shape. Next, an FET chip is soldered onto the substrate. Then, a conductive paste is put on the substrate, and the top of the paste is flattened and suitably hardened to provide spacing pads. Finally, a pyroelectric light receiving element is bonded on the spacing pads.

Since the pyroelectric light receiving element serves to sense changes in temperature by infrared rays, this element is required to be thermally isolated from other components.

To realize this, in the above-mentioned conventional pyroelectric IR-sensor, the pyroelectric light receiving element is spaced from the substrate by the spacing pads and is thus caused to be thermally isolated therefrom.

Since heat is transferred through the spacing pads, however, the thermal isolation is insufficient. Further, since it is extremely difficult to form the spacing pads with a good precision, unevenness occurs in the thermal isolation of the pyroelectric light receiving element. This causes unevenness of the characteristics in the pyroelectric light receiving elements. Furthermore, an unbalance occurs in transfer of heat through a plurality of spacing pads by which the pyroelectric light receiving element is supported. This causes the production of noises by an unbalanced voltage.

In addition, it takes a relatively long time in the process for forming the spacing pads. This constitutes an obstacle to an improvement in productivity.

It would be desirable to be able to provide a pyroelectric IR-sensor which eliminated the above-mentioned problems by employing a structure in which no spacing pad is required.

According to a first aspect of the invention, there is provided a pyroelectric IR-sensor comprising a pyroelectric light receiving element having two end portions thereto, and a substrate for supporting said element, the centre of said substrate being recessed, characterised in that the substrate comprises an MID substrate having two spaced element supporting portions with a wiring pattern thereon, said element supporting portions of the substrate supporting said element, the end portions of which element are connected to said substrate, whereby the centre of said light receiving element is spaced from said MID substrate, and in that element chip parts are mounted on said MID substrate.

The MID substrate in the above-mentioned construction is a substrate of a Moulded Inter Connection Device or circuit mouldings. This substrate is preferably made up or manufactured by a two phase moulding process or two shot melding process.

In the above-mentioned pyroelectric IR-sensor, an MID substrate may be made of resin having a low thermal conductivity. Further, the pyroelectric light receiving element and the MID substrate are in contact with each other only at both end portions of the pyroelectric light receiving element. Accordingly, even if the pyroelectric light receiving element is directly supported by the element supporting portions of the MID substrate, it can be sufficiently thermally isolated.

As a result, it becomes unnecessary to form a spacing pad and there is no possibility that unevenness in the characteristic or noise by an unbalanced voltage may occur.

Not only does the process for forming the spacing pads, which requires considerable time, become unnecessary, but also the three dimensional configuration and the wiring pattern of the MID substrate can be integrally formed by injection moulding, whereby productivity can be improved.

According to a second aspect of the invention, there is provided a pyroelectric IR-sensor comprising light receiving element having two end portions thereto and a substrate for supporting said element, the centre of said substrate being recessed, characterised in that the substrate includes two spaced apart element supporting portions, said light receiving element being supported on said element supporting portions by the end portions of said light receiving element, whereby the central portion of said light receiving element is spaced from said substrate, said substrate having a wiring pattern formed on the surface thereof, and being comprised of a ceramic having a thermal conductivity lower than 0.02 cal/cm.sec.°C, and in that circuit element chip parts are mounted on said substrate.

In the above-mentioned pyroelectric IR-sensor, the thermal conductivity of the substrate is less than 0.02 cal/cm·sec·°C, which is less than one third of that of the conventional sensor of alumina. Further, the pyroelectric light receiving element and the substrate are connected to each other only at both ends of the pyroelectric light receiving element. Accordingly, even if the pyroelectric light receiving element is directly supported by the element supporting portions of the substrate, it can be sufficiently thermally isolated.

Thus, it becomes unnecessary to form spacing pads and there is no possibility that unevenness in the characteristic or noises by an unbalanced voltage may occur. In addition, since the step which requires a relatively long time becomes unnecessary, productivity can be improved.

The present invention will now be described in greater detail by way of examples with reference to the accompanying drawings wherein:
FIG. 1 is an exploded perspective view showing a pyroelectric IR-sensor according to an embodiment of this invention.
FIG. 2 is a flow chart showing a method of manufacturing the pyroelectric IR-sensor shown in FIG. 1.
FIG. 3 is an electric circuit diagram of the pyroelectric IR-sensor shown in FIG. 1.
FIG. 4 is a spread perspective view showing a pyroelectric IR-sensor according to another embodiment of this invention.
FIG. 5 is a flowchart showing a method of manufacturing the pyroelectric IR-sensor shown in FIG. 4.

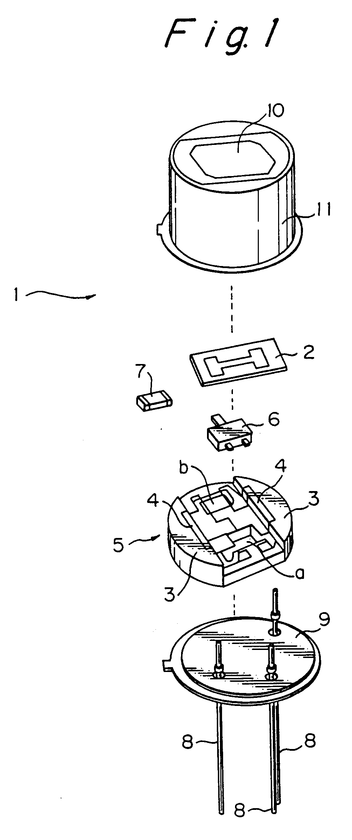

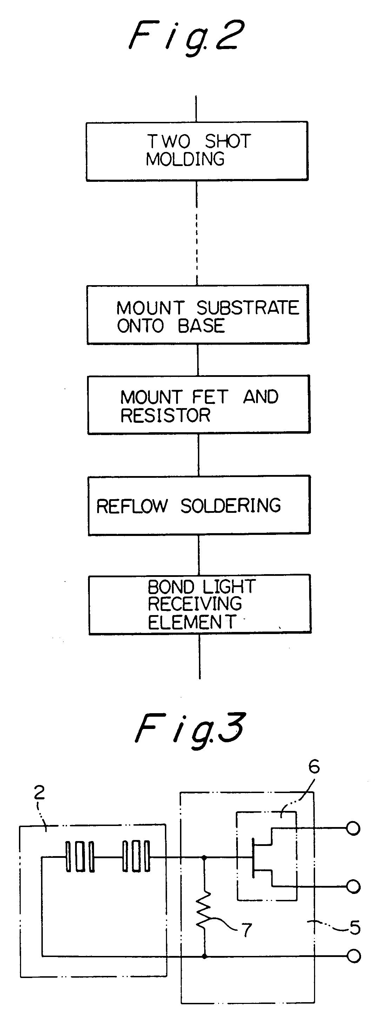

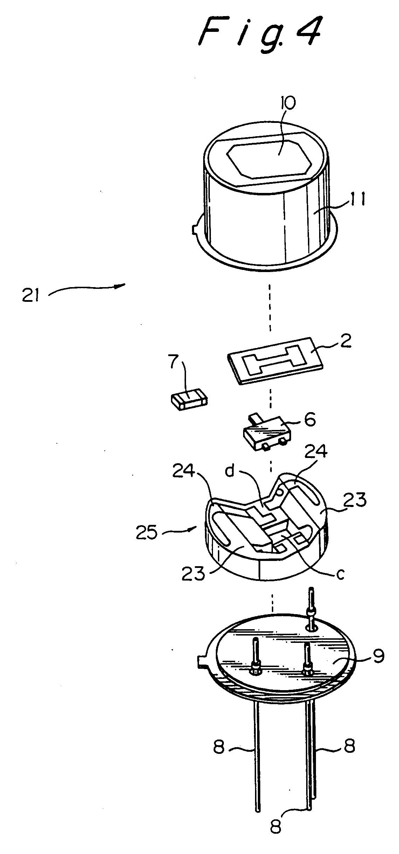

In a pyroelectric IR-sensor 1 according to an embodiment of this invention shown in FIG. 1, a pyroelectric light receiving element 2 is the same as the conventional one of the dual-element type.

An MID substrate 5 is made up as follows. First, a catalytic resin is used to injection-mould a catalytic resin portion having a surface that serves as a wiring pattern. Then, a non-catalytic resin is used to injection-mould a non-catalytic resin portion having a surface which serves as an insulating surface so that it overlaps the catalytic resin portion. Further, a conductive layer is formed on the surface of the catalytic resin portion by electroless plating, thus allowing the conductive layer to be a wiring pattern 4. It is preferable that both the catalytic resin and the non-catalytic resin have a thermal conductivity as small as possible, and a heat-resisting property as high as possible.

The MID substrate 5 is concave so that both end portions of the pyroelectric light receiving element 2 can be supported with the central portion thereof being spaced therefrom.

This MID substrate 5 is mounted on a base 9. Further, an FET chip 6 is mounted on the portion a and a resistor chip 7 is mounted on the portion b of the MID substrate 5.

These components are soldered by solder paste/reflow.

Further, the two end portions of the pyroelectric light receiving element 2 are bonded to the element supporting portions 3 and 3 of the MID substrate 5. It is preferable that this bonding is effected by using a conductive epoxy bonding agent in order to suppress the heat conduction.

Finally, the article thus obtained is sealed by a case 11 having an optical filter 10 as a window and N₂ gas is filled therein.

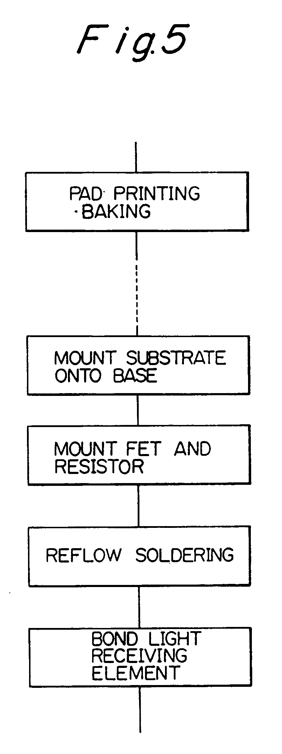

FIG. 2 is a flowchart showing the basic part of a method of manufacturing the above-mentioned pyroelectric IR-sensor 1.

FIG. 3 is an electric circuit diagram thereof.

The following advantages can be provided by the pyroelectric IR-sensor 1.
1. Since a structure is employed such that the pyroelectric light receiving element 2 is directly supported by the MID substrate 5, the process for forming a spacing pad becomes unnecessary and the manufacturing becomes easy. Further, the mechanical strength is improved, so the pyroelectric light receiving element can tolerate impact or vibrations.
2. Since a structure is employed such that only both ends of the pyroelectric light receiving element 2 are supported by a resin having a low thermal conductivity, the thermal isolation becomes satisfactory and unevenness in the characteristic is reduced. Further, the possibility that noises due to an unbalanced voltage may be produced is eliminated.

FIG. 4 shows a pyroelectric IR-sensor 21 according to another embodiment of this invention.

In this pyroelectric IR-sensor 21, the pyroelectric light receiving element 2 is the same as the conventional one.

A substrate 25 is made of a ceramic having a thermal conductivity lower than 0.02 cal/cm·sec·°C. For such a material, (MgCa) TiO₃ ceramics having a thermal conductivity of 0.017 cal/cm·sec·°C, a specific dielectric constant of 20, and a specific resistance value more than 10¹³ Ω cm, or BaO - SiO₂ - A1₃ ceramics having a thermal conductivity of 0.004 cal/cm·sec·°C, a specific dielectric constant of 6, and a specific resistance value more than 10¹³ Ω cm may be used. It is preferable that the thermal conductivity and the specific dielectric constant are as small as possible, and the resistance (volume resistivity) is as high as possible.

The substrate 25 is concave so that the two end portions of the pyroelectric light receiving element 2 can be supported by element supporting portions 23 and 23 with the central portion thereof being spaced from the substrate 25.

Further, a wiring pattern 24 of a silver electrode is formed on the surface of the substrate 25 by using pad type transfer printing. Since wiring pattern 24 can be formed on a three-dimensional body by a single step by using pad type transfer printing, the manufacturing process becomes easy.

This substrate 25 is mounted on a base 9. In addition, an FET chip 6 is mounted on the portion c and a resistor chip 7 is mounted on the portion d of the substrate 25.

These components are soldered by solder paste/reflow.

Further, the two end portions of the pyroelectric light receiving element 2 are bonded to element supporting portions 23 and 23 of the substrate 25. It is preferable that this bonding is effected by using a conductive epoxy bonding agent in order to suppress the heat conduction.

Finally, the article thus obtained is sealed by a case 11 having an optical filter 10 as a window and N₂ gas is filled therein.

FIG. 5 is a flowchart showing the basic part of a method of manufacturing the above-mentioned pyroelectric IR-sensor 21.

The electric circuit diagram in this embodiment is the same as that shown in FIG. 3.

The following advantages can be provided by the above-mentioned pyroelectric IR-sensor 21.
1. Since a structure is employed such that the pyroelectric light receiving element 2 is directly supported by the substrate 25, the process for forming spacing pads becomes unnecessary and the manufacturing becomes easy. Further, the mechanical strength is improved, so the pyroelectric light receiving element can tolerate impact or vibrations.
2. Since a structure is employed such that a ceramic substrate 25 having a low thermal conductivity is used to support the pyroelectric light receiving element 2 only by the end portions of the substrate 25, the thermal isolation becomes satisfactory and unevenness in the characteristic is reduced. Further, the possibility that noises due to an unbalanced voltage may be produced is eliminated.

## Claims

1. A pyroelectric IR-sensor comprising a pyroelectric light receiving element (2) having two end portions thereto, and a substrate (5) for supporting said element (2), the centre of said substrate (5) being recessed, characterised in that the substrate comprises an MID substrate (5) having two spaced element supporting portions (3) with a wiring pattern (4) thereon, said element supporting portions (3) of the substrate (5) supporting said element (2), the end portions of which element (2) are in contact with said substrate (5), whereby the centre of said light receiving element (2) is spaced from said MID substrate (5), and in that element chip parts (6,7) are mounted on said MID substrate.

2. A pyroelectric IR-sensor according to claim 1, wherein said pyroelectric light receiving element (2) is a dual-element light receiving element.

3. A pyroelectric IR-sensor according to claim 1 or claim 2, wherein said MID substrate (5) is comprised of a first portion of a moulded catalytic resin having a surface with a wiring pattern thereon, and a moulded second portion of a non-catalytic resin with an insulating surface and overlapping said first portion, said light receiving element being connected to said wiring pattern.

4. A pyroelectric IR-sensor according to any one of claims 1 to 3, wherein said chip parts (6,7) include a resistor (7) and an FET (6).

5. A pyroelectric IR-sensor comprising a pyroelectric light receiving element (2) having two end portions thereto and a substrate (25) for supporting said element (2), the centre of said substrate (25) being recessed, characterised in that the substrate (25) includes two spaced apart element supporting portions (23), said light receiving element (2) being supported on said element supporting portions (23) by the end portions of said light receiving element (2), whereby the central portion of said light receiving element (2) is spaced from said substrate (25), said substrate (25) having a wiring pattern (24) formed on the surface thereof, and being comprised of a ceramic having a thermal conductivity lower than 0.02 cal/cm.sec.°C, and in that circuit element chip parts are (6,7) mounted on said substrate (25).

6. A pyroelectric IR-sensor according to claim 5, wherein said wiring pattern (24) is formed by using pad type transfer printing on a surface of said substrate (25).

7. A pyroelectric IR-sensor according to claim 5 or claim 6, wherein said ceramic comprises either (MgCa) Ti0₃ ceramics or BaO - SiO₂ - A1₂O₃ ceramics.

8. A pyroelectric IR-sensor as claimed in any one of claims 1 to 7 in which said circuit element chip parts (6,7) are mounted in the recessed centre portion of said substrate (5, 25).

## Patentansprüche

1. Pyroelektrischer IR-Sensor umfassend ein pyroelektrisches lichtaufnehmendes Element (2) mit zwei Endabschnitten und ein Substrat (5) zum Abstützen des genannten Elements (2), wobei der Mittelabschnitt des genannten Substrats (5) vertieft ist, dadurch gekennzeichnet, daß das Substrat ein MID-Substrat (5) mit zwei beabstandeten elementabstützenden Abschnitten (3) mit einem darauf ausgebildeten Verdrahtungsmuster (4) aufweist, wobei die genannten elementabstützenden Abschnitte (3) des Substrats (5) das genannte Element (2) abstützen, wobei die Endabschnitte dieses Elements (2) mit dem genannten Substrat (5) in Kontakt stehen, wodurch sich der Mittelabschnitt des genannten lichtaufnehmenden Elements (2) im Abstand vom genannten MID-Substrat befindet, und daß Elementchipteile (6, 7) am genannten MID-Substrat angeordnet sind.

2. Pyroelektrischer IR-Sensor nach Anspruch 1, worin das genannte lichtaufnehmende Element (2) ein aus zwei Elementen bestehendes lichtaufnehmendes Element ist.

3. Pyroelektrischer IR-Sensor nach Anspruch 1 oder Anspruch 2, worin das genannte MID-Substrat (5) aus einem ersten Abschnitt eines geformten katalytischen Harzes, das eine Oberfläche mit einem darauf ausgebildeten Verdrahtungsmuster aufweist, und aus einem zweiten geformten Abschnitt eines nichtkatalytischen Harzes mit einer isolierenden Oberfläche besteht, der den ersten genannten Abschnitt überlappt, wobei das genannte lichtaufnehmende Element mit dem genannten Verdrahtungsmuster verbunden ist.

4. Pyroelektrischer IR-Sensor nach einem der Ansprüche 1 bis 3, worin die genannten Chipteile (6, 7) einen Widerstand (7) und einen FET (6) umfassen.

5. Pyroelektrischer IR-Sensor umfassend ein pyroelektrisches lichtaufnehmendes Element (2) mit zwei Endabschnitten und ein Substrat (25) zum Abstützen des genannten Elements (2), wobei der Mittelabschnitt des genannten Substrats (25) vertieft ist, dadurch gekennzeichnet, daß das Substrat (25) zwei voneinander beabstandete elementabstützende Abschnitte (23) enthält, wobei das genannte lichtaufnehmende Element (2) durch die Endabschnitte des genannten lichtaufnehmenden Elements (2) auf den genannten elementabstützenden Abschnitten (23) abgestützt ist, wodurch sich der Mittelabschnitt des genannten lichtaufnehmenden Elements (2) im Abstand vom genannten Substrat (25) befindet, wobei das genannte Substrat (25) ein auf der Oberfläche davon ausgebildetes Verdrahtungsmuster (24) aufweist und aus einem Keramikmaterial besteht, das eine Wärmeleitfähigkeit von weniger als 0,02 kal/cm.sek°C aufweist, und daß die Schaltelementchipteile (6, 7) an genanntem Substrat (25) angeordnet sind.

6. Pyroelektrischer IR-Sensor nach Anspruch 5, worin das genannte Verdrahtungsmuster (24) durch Kissentransferdruck auf einer Oberfläche des genannten Substrats (25) gebildet wird.

7. Pyroelektrischer IR-Sensor nach Anspruch 5 oder Anspruch 6, worin das Keramikmaterial entweder (MgCa) TiO₃-Keramikmaterialien oder BaO - SiO₂ - Al₂O₃-Keramikmaterialien umfaßt.

8. Pyroelektrischer IR-Sensor nach einem der Ansprüche 1 bis 7, worin die genannten Schaltelementchipteile (6, 7) im vertieften Mittelabschnitt des genannten Substrats (5, 25) angeordnet sind.

## Revendications

1. Capteur d'infrarouge pyroélectrique comprenant un élément de réception de lumière pyroélectrique (2) ayant deux portions d'extrémité à celui-ci, et un substrat (5) pour supporter ledit élément (2), le centre dudit substrat (5) étant évidé, caractérisé en ce que le substrat comprend un substrat MID (5) ayant deux portions de support espacées de l'élément (3) avec un motif de câblage (4) sur celles-ci, lesdites portions de support d'élément (3) du substrat (5) supportant ledit élément (2), les portions d'extrémité duquel élément (2) sont en contact avec ledit substrat (5), de la sorte le centre dudit élément de réception de lumière (2) est espacé dudit substrat MID (5), et en ce que des parties de pastilles de l'élément (6, 7) sont montées sur ledit substrat MID.

2. Capteur d'infrarouge pyroélectrique selon la revendication 1, dans lequel l'élément de réception de lumière pyroélectrique (2) est un élément de réception de lumière à deux éléments.

3. Capteur d'infrarouge pyroélectrique selon la revendication 1 ou la revendication 2, dans lequel le substrat MID précité (5) est constitué d'une première portion d'une résine catalytique moulée ayant une surface avec un motif de câblage sur celle-ci, et une seconde portion moulée d'une résine non catalytique avec une surface isolante et recouvrant ladite première portion, ledit élément de réception de lumière étant relié audit motif de câblage.

4. Capteur d'infrarouge pyroélectrique selon l'une quelconque des revendications 1 à 3, dans lequel les parties de pastille précitées (6, 7) comprennent une résistance (7) et un FET (6).

5. Capteur d'infrarouge pyroélectrique comprenant un élément de réception de lumière pyroélectrique (2) ayant deux portions d'extrémité à celui-ci et un substrat (25) pour supporter ledit élément (2), le centre dudit substrat (25) étant évidé, caractérisé en ce que le substrat (25) comprend deux portions de support d'élément espacées l'une de l'autre (23), ledit élément de réception de lumière (2) étant supporté sur lesdites portions de support d'élément (23) par les portions d'extrémité dudit élément de réception de lumière (2), de la sorte la portion centrale dudit élément de réception de lumière (2) est espacée dudit substrat (25), ledit substrat (25) ayant un motif de câblage (24) formé sur la surface de celui-ci, et étant constitué de céramique ayant une conductivité thermique plus faible que 0,02 cal/cmxsecx°C, et en ce que des parties de pastilles de l'élément de circuit (6, 7) sont montées sur ledit substrat (25).

6. Capteur d'infrarouge pyroélectrique selon la revendication 5, dans lequel le motif de câblage précité (24) est formé en utilisant une impression de transfert du type à connexion sur une surface du substrat précité (25).

7. Capteur d'infrarouge pyroélectrique selon la revendication 5 ou la revendication 6, dans lequel la céramique précitée comprend soit des céramiques (MgCa) Ti0₃ soit des céramiques BaO-Si0₂-Al₂0₃.

8. Capteur d'infrarouge pyroélectrique selon l'une quelconque des revendications 1 à 7, dans lequel les parties de pastilles d'élément de circuit précitées (6, 7) sont montées dans la portion de centre évidée du substrat précité (5, 25).
